(19) **Europäisches Patentamt**
**European Patent Office**
**Office européen des brevets**

(11) **EP 1 780 239 B1**

(12) **EUROPEAN PATENT SPECIFICATION**

(45) Date of publication and mention
of the grant of the patent:
**01.02.2017 Bulletin 2017/05**

(51) Int Cl.:
***C08L 63/00*** *(2006.01)*  ***H01L 23/29*** *(2006.01)*
***H01L 23/31*** *(2006.01)*  ***C08L 51/04*** *(2006.01)*

(21) Application number: **05770486.8**

(22) Date of filing: **11.08.2005**

(86) International application number:
**PCT/JP2005/014779**

(87) International publication number:
**WO 2006/019041 (23.02.2006 Gazette 2006/08)**

(54) **EPOXY RESIN COMPOSITION FOR SEMICONDUCTOR SEALING AGENTS AND EPOXY RESIN MOLDING MATERIAL**

EPOXIDHARZZUSAMMENSETZUNG FÜR HALBLEITERVERSIEGELUNGSMITTEL UND EPOXIDHARZ-FORMMASSE

COMPOSITION DE RESINE EPOXY POUR AGENTS D'ETANCHEITE SEMI-CONDUCTEURS ET MATERIAU DE MOULAGE DE RESINE EPOXY

(84) Designated Contracting States:
**AT BE BG CH CY CZ DE DK EE ES FI FR GB GR HU IE IS IT LI LT LU LV MC NL PL PT RO SE SI SK TR**

(30) Priority: **18.08.2004 JP 2004238691**

(43) Date of publication of application:
**02.05.2007 Bulletin 2007/18**

(73) Proprietor: **Kaneka Corporation**
**Osaka (JP)**

(72) Inventors:
• **YAMAGUCHI, Katsumi**
**Takasago-shi, Hyogo 6768688 (JP)**
• **NAKAJIMA, Nobumasa**
**Takasago-shi, Hyogo 6768688 (JP)**
• **FURUKAWA, Yoshio**
**Takasago-shi, Hyogo 6768688 (JP)**

(74) Representative: **Vossius & Partner**
**Patentanwälte Rechtsanwälte mbB**
**Siebertstrasse 3**
**81675 München (DE)**

(56) References cited:
WO-A1-87/00188     WO-A1-2004/108825
WO-A1-2005/028546     CA-A1- 2 164 915
JP-A- 2000 265 038     JP-A- 2000 313 818
JP-A- 2004 018 803     JP-A- 2004 315 572

**EP 1 780 239 B1**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to an epoxy resin composition and an epoxy resin molding material for sealing semiconductor, i.e. semiconductor sealing materials, wherein a core-shell polymer including reduced contaminants is dispersed in the form of primary particles in the epoxy resin, the epoxy resin composition and the epoxy resin molding material achieving a good balance among heat resistance, peeling resistance, thermal shock resistance, moisture resistance reliability, and internal-stress relaxation and having excellent handling and reproducibility of physical characteristics.

Background Art

Epoxy resin compositions that have been widely used as, for example, semiconductor sealing materials are good materials having high mechanical strength, heat resistance, electrical insulation, adhesiveness, etc. However, in the case of the use of the epoxy resin composition as a semiconductor sealing material, residual stress occurs in the sealing material because of a combination of the difference of the linear expansion coefficients between the sealing material and a substrate material or a device to be sealed, cure shrinkage, and high-temperature conditions in reflowing or the like. As a result, the sealing material has the occurrence of the disadvantages such as interfacial peeling, cracks, and the like at the interface between the sealing material and the substrate or the device to be sealed. The following known methods have been widely employed to improve these disadvantages: for example, a method for compounding a significantly large amount of a filler, such as silica, to bring the linear expansion coefficient of an epoxy resin composition close to that of a material of a substrate; or a method for adding a rubber component to an epoxy resin composition used to reduce the stress of the epoxy resin composition.

As a method for improving impact resistance of an epoxy resin by addition of a rubber component or a method for reducing stress of an epoxy resin, there has been known, for example, a method of adding a reactive liquid rubber (e.g., carboxyl-terminated butadiene-acrylonitrile (CTBN)) or a nitrile rubber (e.g., Japanese Patent Publication No. 62-34251). However, since the reactive liquid rubber is dissolved in an epoxy resin and then phase-separated during curing, the morphology of the resulting cured product is changed depending on the type of epoxy resin compounded and curing conditions; therefore, the effect of reducing stress is not desirably obtained, or reproducibility of quality is poor. In addition, since the rubber component is partially dissolved and remains in the epoxy resin phase after curing, the elasticity modulus, glass transition temperature (hereinafter, also referred to as "Tg") of the cured product, or adhesive strength between a sealing material and a substrate or a device to be sealed is decreased, thus degrading the quality of the sealing material.

To solve the disadvantageous change in morphology due to the addition of the rubber component and to control the change in morphology, there has been known a method for conducting polymerization of a monomer, such as an acrylate, in an epoxy resin to prepare a composition containing rubber particles dispersed in the epoxy resin (Japanese Patent Laid-open Publication No. 59-138254).

CA2164915 discloses an epoxy resin composition comprising diglycidyl ether-core-shell polymer suspension wherein the core-shell polymer is for example a polybutadiene (core) - methyl methacrylate (shell) used as a toughener.

However, the partial dissolution of the rubber component in the epoxy resin phase after curing is unavoidable even with the above-described process, and a glass transition temperature is decreased in some cases; hence, quality is insufficient.

To solve such problems, a method for adding rubbery polymer particles insoluble in the epoxy resin to an epoxy resin has been known (for example, Japanese Patent Laid-open Publication No. 10-287792). By employing this method, since the rubber component is not dissolved in the epoxy resin phase after curing, it is possible to suppress deterioration in heat resistance (glass transition temperature). In this case, the rubbery polymer particles are not prepared by polymerization in the epoxy resin, but previously prepared by polymerization before being mixed with the epoxy resin. Since such rubber particles each have a crosslinked structure therein, the structure of the particles is fixed. However, it is relatively difficult to impart satisfactory compatibility and affinity with the epoxy resin component to the rubber particles. Furthermore, despite the crosslinked structure, in practical handling, it is more difficult to disperse the particles because of the occurrence of fusion or adhesion of the surfaces of the rubber particles. Therefore, in a step of adding the rubber particles to the epoxy resin, it is necessary to, for example, previously mix a compound, such as talc, used for preventing blocking of the rubber particles, or it is necessary to adequately perform kneading under high shear force for a long time to disperse the particles in the epoxy resin. Furthermore, in a step of curing the epoxy resin, there is a possibility of reaggregation of the rubber-particle component that has been dispersed once. Thus, it is not easy to obtain a desired dispersion state, and a satisfactory performance is not always exhibited.

Furthermore, to improve an affinity in the interface between the rubber particle component and the epoxy resin and to improve a dispersion state of the rubber particles in a resin matrix component, a method for adding what is called core-shell polymer is employed. In order to improve impact resistance by finely dispersing a rubber particle phase in a resin matrix phase, a method for adding the core-shell polymer as the rubber component to the resin matrix phase have been widely tried in system using thermoplastic resins as dispersion media. And, in some of thermosetting resin systems, attempts to apply the above-described method have also been made (for example, US Patent Nos. 3322852 and 3496250). Such core-shell polymers have been widely available in the market under the trade name of Kane Ace (manufactured by Kaneka Corporation), Paraloid (manufactured by Rohm and Hass Company), and the like. However, typically, these are commercially available in the form of powders each having a particle size of several tens to several hundreds of micrometers, and the powders are constituted of aggregates of primary particles. Thus, when the core-shell polymers are mixed with epoxy resins, it is necessary to, for example, previously pulverize the powdered core-shell polymers into fine particles each having a particle size of less than 10$\mu$m before mixing or to perform mixing under high shear force at high temperature during mixing. Even when the core-shell polymer is mixed with an epoxy resin through such a complicated procedure, the following problem often occurs: for example, a core-shell polymer that has been dispersed once is easily separated, e.g., precipitated or floated; or the particles of the core-shell polymer are not completely dispersed in the form of primary particles but are dispersed in the form of aggregates.

In addition to above, it is usually difficult to remove electrolytes such as emulsifiers and contaminants added during polymerization of a core-shell polymer effectively, from the core-shell polymer being in the form of a powder. These electrolytes or contaminants cause, for example, a crack during reflowing due to moisture absorption of the sealing material; or deterioration in electrical insulation, thus resulting in a drop of the reliance of the sealing material. To prevent this, for example, a highly specific method is required in the method including the steps of performing polymerization using a quite large amount of nonionic emulsifier having relatively low polymerization stability and then performing thermal aggregation at a cloudy point or higher temperature of the nonionic emulsifier without coagulation using an electrolyte; or in combination therewith isolating the resulting polymer by a special process, for example, spray drying or freeze-coagulation. Thus, the method is not enough practical. Furthermore, in such a method, even when a large amount of nonionic emulsifier is used, it is difficult to maintain polymerization stability during polymerization, thus polymerization stability may be insufficient when a core-shell polymer is prepared by multistage emulsion polymerization in commercial scale. Thus the method is not considered to be widely employed so far except for a few methods for preparing non-core-shell polymers by single-step emulsion polymerization.

As described above, in the present circumstances, a known sealing material containing an epoxy resin composition compounded with a core-shell polymer in a powder form has not only poor handling property and inferior reproducibility of physical properties but also an unsatisfactory balance among heat resistance, peeling resistance, thermal shock resistance, moisture resistance reliability, and internal stress relaxation.

In addition to these circumstances, in recent years, from the viewpoint of environmental protection, solder materials used for electrically connecting electronic devices have been moving from conventional lead-containing solder to lead-free solder. However, lead-free solder having satisfactory connection reliability similar to that of conventional lead-containing solder has a melting point of 30 °C to 40 °C higher than that of the conventional lead-containing solder, thus leading to a further increase in reflow temperature in mounting electrical devices in the future. In the present circumstances, the development of an epoxy resin sealing material having further improved balance among heat resistance, peeling resistance, thermal shock resistance, moisture resistance reliability, and internal stress relaxation is more highly desired beyond a level required for a conventional epoxy resin sealing material.

Disclosure of the Invention

Problems to be Solved by the Invention

It is an object of the present invention to provide an epoxy resin composition and an epoxy resin molding material for sealing semiconductor devices, the epoxy resin composition and the epoxy resin molding material being capable of overcoming the above-described various problems of conventional epoxy resin compositions or epoxy resin molding materials and having a high level balance among heat resistance, the capability of decreasing stress, and moisture resistance reliability, and having, excellent handling property and reproducibility of physical properties.

Means for Solving Problems

The present invention relates to an epoxy resin composition (C) for sealing semiconductor, including an epoxy resin (A); and a core-shell polymer (B) as described in claim 1 comprising a rubber particle core (B-1) and a shell layer (B-2), wherein the shell layer (B-2) of the core-shell polymer (B) contains an epoxy group, and the epoxy equivalent value is not more than 4,500 for the entire core-shell polymer (B), at least 70% of the core-shell polymer (B) being dispersed in the form of primary particles in a resin phase containing the epoxy resin, and the content of an alkali metal ion of the epoxy resin composition (C) being 30 ppm or less.

In a preferred embodiment related to the epoxy resin composition (C) for sealing semiconductor described above, the epoxy resin composition (C) contains 100 ppm or less of an anionic emulsifier.

In another preferred embodiment related to the epoxy resin composition (C) for a sealing semiconductor described in any one of the embodiments, the epoxy resin composition (C) is prepared by mixing an aqueous latex including the core-shell polymer (B) containing at least one rubber layer with an organic solvent (I) to form a mixture (F), bringing the mixture (F) into contact with water to form aggregates (G) of the core-shell polymer (B) in an aqueous phase (H), the aggregates (G) containing the organic solvent (I), separating the aggregates (G) from the aqueous phase (H), and mixing the aggregates (G) with the epoxy resin (A).

In another preferred embodiment related to the epoxy resin composition (C) for sealing semiconductor described in any one of the embodiments, the epoxy resin composition (C) is prepared by mixing an aqueous latex including the core-shell polymer (B) containing at least one rubber layer with an organic solvent (I) to form a mixture (F), bringing the mixture (F) into contact with water to form aggregates (G) of the core-shell polymer (B) in an aqueous phase (H), the aggregates (G) containing the organic solvent (I), separating the aggregates (G), adding the organic solvent (I) to form a dispersion (E) containing the core-shell polymer (B) dispersed in an organic solvent (I), and mixing the dispersion (E) with the epoxy resin (A).

In another preferred embodiment related to the epoxy resin composition (C) described in any one of the embodiments, in preparing the epoxy resin composition (C), before mixing the dispersion (E) with the epoxy resin (A), steps of bringing the dispersion (E) into contact with water and then separating an aqueous phase are performed at least once.

In another preferred embodiment related to the epoxy resin composition (C) for a sealing semiconductor described in any one of the embodiments, at least 90% of the core-shell polymer (B) is dispersed in the form of primary particles in the resin phase containing the epoxy resin, and the content of the alkali metal ion of the epoxy resin composition (C) is 15 ppm or less.

In another preferred embodiment related to the epoxy resin composition (C) for a sealing semiconductor described in the above embodiment, the epoxy resin composition (C) contains 60 ppm or less of an anionic emulsifier.

In the epoxy resin composition (C) described in any one of the embodiments, the core-shell polymer (B) is a polymer including a multilayer structure containing at least two layers containing at least one crosslinked rubber polymer layer.

In the epoxy resin composition (C) described above the core-shell polymer (B) is a graft copolymer comprising 40 to 95 percent by weight of the rubber particle core (B-1) and 5 to 60 percent by weight of the shell layer (B-2), wherein the rubber particle core (B-1) contains a rubber elastomer, a rubbery polysiloxane elastomer, or a mixture rubber thereof, the rubber elastomer containing at least 50 percent by weight of at least one monomer selected from a diene monomer and a (meth)acrylate monomer and 50 percent by weight or less of other copolymerizable vinyl monomer, and the shell layer (B-2) contains a polymer prepared by polymerizing at least one polymerizable vinyl monomer selected from a (meth)acrylate, an aromatic vinyl, vinyl cyanide, an unsaturated acid derivative, a (meth)acrylamide derivative, and a maleimide derivative, and the shell layer (B-2) further comprises an epoxy group and the epoxy equivalent value is not more than 4,500 for the entire core-shell polymer (B).

In another preferred embodiment related to the epoxy resin composition (C) described in any one of the embodiments, the epoxy resin (A) includes 50 percent by weight or more of at least one epoxy resin selected from a diglycidyl ether of a biphenol or an aromatic nucleus-substituted biphenol or a condensate thereof, a novolac-type epoxy resin, a dicyclopentadienyl-type epoxy resin, and an alicyclic epoxy resin containing a cycloolefin oxide skeleton structure per molecule, for the total amount of epoxy resin (A).

The present invention further relates to an epoxy resin molding material for sealing semiconductor, which comprises the epoxy resin composition (C) described in any one of the embodiments, a curing agent (K), an inorganic filler (L), and if necessary, a curing accelerator (M).

Advantages of the Invention

Use of an epoxy resin composition of the present invention for an epoxy resin molding material for sealing semiconductor devices results in satisfactory handling and excellent reproducibility of physical properties, overcoming various problems of conventional rubber-modified epoxy resin molding materials for sealing semiconductor devices, and high-level balance among heat resistance, the ability of decreasing stress, and reliance in moisture resistance compared with the known materials. This is because the epoxy resin composition containing a core-shell polymer is prepared by a specific method, the core-shell polymer with significantly decreased contaminants being stably dispersed in the form of primary particles.

Best Mode for Carrying Out the Invention

The present invention relates to an epoxy resin composition containing a core-shell polymer stably dispersed in the form of primary particles and containing decreased contaminants. Furthermore, the present invention relates to an epoxy resin molding material for sealing semiconductor devices containing the epoxy resin composition.

An epoxy resin (A) used in the present invention is available from epoxy resins generally used as molding materials for sealing semiconductor devices. Examples thereof widely include novolac-type epoxy resins, such as phenol novolac-type epoxy resins and cresol novolac-type epoxy resins, prepared by glycidyl etherification of novolac resins prepared by condensation of phenols, biphenols, or naphthols with aldehydes; biphenyl-type epoxy resins, such as 2,2',6,6'-tetramethylbiphenoldiglycidyl ether; polyglycidyl ethers of polyhydric phenols, such as biphenols, aromatic nucleus-substituted biphenols, and bisphenol-A, F, and S, or polyglycidyl ethers of polyhydric alcohols, such as trimethylolpropane, or their condensates; or alicyclic epoxy resins each containing cycloolefin oxide skeleton structure(s) per molecule. Among these compounds, the epoxy resin (A) preferably contains 50 percent by weight or more of at least one epoxy resin selected from diglycidyl ethers of biphenols or aromatic nucleus-substituted biphenols or condensates of these, novolac-type epoxy resins, dicyclopentadienyl-type epoxy resins, and alicyclic epoxy resins containing cycloolefin oxide skeleton structure(s) per molecule, for the total amount of epoxy resin (A).

A core-shell polymer (B) usable in the present invention is a core-shell polymer including at least one rubber layer. The core-shell polymer (B) preferably includes a rubber particle core (B-1) composed of a polymer principally containing a polymer having rubber elasticity and a shell layer (B-2) composed of a polymer component prepared by graft polymerization with the rubber particle core (B-1).

A polymer constituting the rubber particle core (B-1) is preferably crosslinked, and the polymer is preferably capable of swelling with a good solvent of the polymer but substantially insoluble in the solvent, and insoluble in the epoxy resin. The content of gel in the core portion is preferably 60 percent by weight or more, more preferably 80 percent by weight or more, particularly preferably 90 percent by weight or more, and most preferably 95 percent by weight or more. The polymer constituting the core portion preferably is having the properties of rubber, thus having a glass transition temperature (Tg) of 0 °C or less and preferably -10 °C or less.

The polymer constituting the rubber particle core (B-1) preferably includes an rubber elastomer containing 50 percent by weight or more of at least one monomer selected from the group consisting of diene monomers (conjugated diene monomers) and (meth)acrylic ester monomers and 50 percent by weight or less of another copolymerizable vinyl monomer; a polysiloxane rubber; or a combination of these. In the present invention, "(meth)acrylic" means acrylic and/or methacrylic.

Examples of the conjugated diene monomer constituting the rubber elastomer include butadiene, isoprene, and chloroprene. Butadiene is particularly preferable Examples of the (meth)acrylic ester monomer include butyl acrylate, 2-ethylhexyl acrylate, and lauryl methacrylate. Butyl acrylate and 2-ethylhexyl acrylate are particularly preferable. These may be used alone or in combination.

The amount of at least one monomer used, the monomer being selected from the group consisting of conjugated diene monomers and (meth)acrylic ester monomers, is preferably 50 percent by weight or more and more preferably 60 percent by weight or more for the total weight of the core portion (B-1). At less than 50 percent by weight, there is a tendency to reduce the ability of decreasing stress of an epoxy resin.

In addition to the conjugated diene monomer or (meth)acrylic ester monomer, the rubber elastomer may be a polymer/copolymer of the conjugated monomer or the (meth)acrylic ester monomer, or a copolymer of above monomer (s) and other vinyl monomer copolymerizable therewith. Examples of the vinyl monomer copolymerizable with the conjugated diene monomer or the (meth) acrylic ester monomer include vinyl monomers selected from the group comprising aromatic vinyl monomers and vinylcyanide monomers. Examples of the aromatic vinyl monomer that can be used include styrene, $\alpha$-methylstyrene, and vinylnaphthalene. Examples of the vinylcyanide monomer that can be used include (meth)acrylonitrile and substituted acrylonitriles. These may be used alone or in combination. The amount of the copolymerizable vinyl monomer used is preferably 50 percent by weight or less, more preferably less than 50 percent by weight, and particularly preferably 40 percent by weight or less for the total weight of the rubber elastomer.

To adjust the degree of crosslinking, a polyfunctional monomer may be contained as a component constituting the rubber elastomer. Examples of the polyfunctional monomer include divinylbenzene, butanediol di(meth)acrylate, triallyl (iso)cyanurate, allyl (meth)acrylate, diallyl itaconate, and diallyl phthalate. The amount of the polyfunctional monomer used is 10 percent by weight or less, preferably 5 percent by weight or less, and more preferably 3 percent by weight or less for the total weight of core portion (B-1). Using amount of the polyfunctional monomer exceeding 10 percent by weight tend to drop the ability of stress reduction of an epoxy resin.

To adjust the molecular weight or the degree of crosslinking of the polymer constituting the rubber elastomer, a chain-transfer agent may be used. A specific example thereof is an alkyl mercaptan having 5 to 20 carbon atoms. The amount of the chain-transfer agent used is 5 percent by weight or less and more preferably 3 percent by weight or less for the total weight of core portion (B-1). At the amount of chain-transfer agent used exceeding 5 percent by weight, in some cases, the amount of an uncrosslinked component in the rubber particle core (B-1) is increased, thus giving negative influences on, for example, heat resistance and viscosity of the epoxy resin composition.

As the rubber particle core (B-1), a polysiloxane rubber may also be used instead of or in combination with the previously mentioned rubber elastomer. In the use of the polysiloxane rubber as the rubber particle core (B-1), examples of the polysiloxane rubber that can be used include polysiloxane rubbers containing an alkyl- or aryl-disubstituted silyloxy unit, such as dimethylsilyloxy, methylphenylsilyloxy, and diphenylsilyloxy. When such a polysiloxane rubber is used, if necessary, a crosslinked structure is preferably introduced by the following typical method: a method of adding a polyfunctional alkoxysilane compound in polymerization; a method of introducing a reactive group, such as a reactive vinyl group or a mercapto group, and then adding a vinyl-polymerizable monomer or an organic peroxide to cause radical reaction; or a method of adding a crosslinkable monomer, such as a polyfunctional vinyl compound or a mercapto group-containing compound, after polymerization for the polysiloxane rubber, and then performing polymerization.

Preferably, from the stand point of the affinity between the epoxy resin and the core-shell polymer, a polymer constituting the shell layer (B-2) is grafted onto the polymer constituting the rubber particle core (B-1) by graft polymerization and is substantially bonded to the polymer constituting the rubber particle core (B-1). In the polymer constituting the shell layer (B-2), preferably 70 percent by weight or more, more preferably 80 percent by weight or more, and still more preferably 90 percent by weight or more of the polymer is desirably bonded to the rubber particle core (B-1).

The shell layer (B-2) is intended to impart affinity for the epoxy resin (A) to the core-shell polymer (B) so that the core-shell polymer (B) is stably dispersed in the form of primary particles in the epoxy resin composition (C). The shell layer (B-2) preferably has swelling property, miscibility (compatibility), or affinity to an organic solvent (I) described below and the epoxy resin (A). In the present invention, "the core-shell polymer (B) being dispersed in the form of primary particles" means that the core-shell polymer particles are not aggregated together in the epoxy resin (A), but each particle is dispersed independently.

The shell layer (B-2) preferably has reactivity to the epoxy resin (A) or a curing agent compounded in the practical use, according to the necessity. This makes the shell layer (B-2) have the function of causing chemical reaction with the epoxy resin (A) or curing agent to form bondings under the conditions that the epoxy rein (A) is reacted with the curing agent to cause curing, whereby the re-aggregation of the core-shell polymer and deterioration of the dispersion state are effectively prevented under the curing conditions.

The polymer constituting the shell layer (B-2) is preferably a copolymer prepared by copolymerizing at least one monomer containing an epoxy group as a functional group, with at least one component selected from the (meth)acrylates, aromatic vinyl compounds, vinylcyanide compounds, unsaturated acid derivatives, (meth)acrylamide derivatives, or maleimide derivatives, the functional group having reactivity to the epoxy resin (A), a curing agent, or a curing catalyst described below. The core-shell polymer (B) particularly contains an epoxy group as the reactive functional group so that the epoxy equivalent value is 4,500 or less for the total weight of the core-shell polymer (B) because it is possible to effectively suppress the reaggregation of the particles of the core-shell polymer (B) under curing conditions and ensure a satisfactory dispersion state before and after curing.

Examples of the (meth) acrylates include alkyl (meth) acrylates such as methyl (meth)acrylate, ethyl (meth)acrylate, butyl (meth)acrylate, and 2-ethylhexyl (meth)acrylate. Examples of the aromatic vinyl compounds include styrene, α-methylstyrene, alkyl-substituted styrene, and halogen-substituted styrenes such as bromostyrene and chlorostyrene. Examples of the vinylcyanide compounds include (meth)acrylonitrile and substituted acrylonitrile. Examples of the reactive functional group-containing monomers include reactive side-chain-containing (meth)acrylates such as 2-hydroxyethyl (meth)acrylate, 2-aminoethyl (meth)acrylate, and glycidyl (meth)acrylate. Examples of a vinyl ether containing a reactive group include glycidyl vinyl ether and allyl vinyl ether. Examples of an unsaturated carboxylic acid derivative include (meth)acrylic acid, itaconic acid, crotonic acid, and maleic anhydride. An example of the (meth)acrylamide derivatives is (meth)acrylamide (including N-substituted (meth)acrylamide). An example of the maleimide derivatives is maleimide (including N-substituted maleimide).

The weight ratio of the rubber particle core (B-1) to the shell layer (B-2) of the core-shell polymer (B), i.e., (B-1)/(B-2), is preferably in the range of 40/60 to 95/5 and more preferably 60/40 to 90/10. When the ratio of the core (B-1) decreases, and the ratio (B-1)/(B-2) is lower than the above range (40/60), there is a tendency to decrease the effect of stress reduction of the epoxy resin composition of the present invention. When the ratio of the shell layer (B-2) decreases, and the ratio (B-1)/(B-2) is larger than the above ratio (95/5), aggregation easily occurs during the process condition of the present invention. As a result, handling property becomes worse, and desired physical properties are not obtained, in some cases.

A production method of the core-shell polymer (B) is not particularly limited and produced by a widely known method, such as emulsion polymerization, suspension polymerization, or microsuspension polymerization. Among these, a production method of multistage emulsion polymerization is suitable. Specific examples of an emulsifier (dispersant) used in an aqueous medium include alkali metal salts or ammonium salts of various acids, for example, alkylsulfonic acids, such as dioctyl sulfosuccinic acid, and arylsulfonic acids such as dodecylbenzenesulfonic acid; alkyl ether sulfonic acids and aryl ether sulfonic acids; alkylsulfuric acids, such as dodecylsulfuric acid, and arylsulfuric acids; alkyl or aryl ether sulfuric acids; alkyl- or aryl-substituted phosphoric acids; alkyl or aryl ether-substituted phosphoric acids; N-alkylsarcosines, such as dodecylsarcosine, and arylsarcosines; alkylcarboxylic acids, such as oleic acid and stearic acid, and arylcarboxylic acids; and alkyl or aryl ether carboxylic acids ; nonionic emulsifiers or dispersants, such as alkyl or aryl-substituted polyethylene glycol; and other dispersants, such as polyvinyl alcohol, alkyl-substituted cellulose, polyvinylpyrrolidone, and polyacrylic acid derivatives. These compounds may be used alone or in appropriate combination.

In view of the gist of preferred embodiments of the present invention, each of these emulsifiers (dispersants) is more preferably used in an as small amount as possible without interference with dispersion stability in a step of preparing a latex of the core-shell polymer (B). Alternatively, each of these emulsifiers (dispersants) more preferably has water-solubility so as to be extracted and removed during the process of preparing the epoxy resin composition of the present invention to the extent that the remaining emulsifier (dispersant) has no negative influence on physical properties of the epoxy resin composition to be produced.

The content of the core-shell polymer (B) that can be used in the present invention is usually in the range of 1 to 50 percent by weight, preferably 2 to 20 percent by weight, and more preferably 3 to 10 percent by weight for the total weight of the epoxy resin composition (C) or the epoxy resin composition containing the epoxy resin composition (C) in combination with an appropriate epoxy resin according to need. When the content of the core-shell polymer (B) is less than 1 percent by weight, effect of stress reduction may not be enough obtained. When the content of the core-shell polymer (B) exceeds 50 percent by weight, the resulting epoxy resin molding material for sealing semiconductor devices may not have enough heat resistance.

The particle size of the core-shell polymer (B) that can be used in the present invention is not particularly limited. Any particle size can be used as long as the core-shell polymer (B) can be stably obtained in the form of an aqueous latex. From the standpoint of industrial productivity, i.e., ease of production, the volume-average particle size is preferably 0.03 to 2.0 $\mu$m and more preferably 0.04 to 1.0 $\mu$m. The volume-average particle size of the core-shell polymer (B) can be measured by a known method, for example, using Microtrac UPA (manufactured by Nikkiso Co. , Ltd.).

The epoxy resin composition (C) used in an epoxy resin molding material of the present invention is preferably prepared by a specific production process. An example of the specific production process is a process in which the core-shell polymer (B) prepared in the form of an aqueous latex is mixed with an organic solvent to transfer the core-shell polymer (B) into an organic phase, thus resulting in a dispersion (E) containing the core-shell polymer (B) dispersed in the organic solvent, and then the resulting dispersion (E) is mixed with the epoxy resin (A). The epoxy resin composition (C) used in an epoxy resin molding material of the present invention is preferably prepared by such a specific production process. By employing the production process, it is possible to prepare an epoxy resin composition in which most of the core-shell polymer (B) is dispersed in the form of primary particles in the epoxy resin (A) matrix, and in the same time, contaminants such as an emulsifier and alkali metal ions, usually contained in a core-shell polymer are significantly decreased. Examples of such a process include processes disclosed in Japanese Patent Application Nos. 2003-107882, 2003-164416, and 2003-326711.

To be more specific, an exemplary process for producing the dispersion (E) containing the core-shell polymer (B) dispersed in the organic solvent includes bringing a mixture (F) of an aqueous latex containing the core-shell polymer (B) and a specific organic solvent (I) into contact with water to form aggregates (G) of the core-shell polymer (B) including the organic solvent (I) in an aqueous phase (H) ; separating the aggregates (G); and redispersing the aggregates (G) into an organic solvent (I).

By mixing the resulting dispersion (E) with the epoxy resin (A) and, if necessary, by removing a volatile component including the organic solvent, it is possible to produce the epoxy resin composition (C) used in an epoxy resin molding material of an present invention.

An alternative process for producing the epoxy resin composition (C) includes mixing the resulting aggregates (G) with the epoxy resin (A).

In the epoxy resin composition (C) prepared by such processes, most of the core-shell polymer (B) is dispersed in the form of primary particles in the epoxy resin (A) matrix. To be specific, at least 70% of the core-shell polymer (B) and preferably at least 90% of the core-shell polymer (B) is dispersed in the form of primary particles in the epoxy resin (A) matrix.

Furthermore, another advantage of these processes is that, in the step of transferring the core-shell polymer (B) from the aqueous latex containing the core-shell polymer (B) into the organic phase, most of electrolytes or water-soluble materials, such as an emulsifier, a dispersant, a water-soluble polymerization initiator, and a reductant, used in preparing the aqueous latex containing the core-shell polymer (B) are eluted to the aqueous phase when the aggregates (G) are formed and thus can be removed from the aggregates (G) due to the difference of distribution ratio (between organic solvent phase and aqueous phase). Therefore, such water-soluble contaminants can be decreased or removed effectively and efficiently while performing the step of dispersing the core-shell polymer (B) into the organic solvent.

More preferably, by bringing the dispersion (E) containing the core-shell polymer (B) in the organic solvent into contact with water and then performing the step of separating and removing the resulting aqueous phase at least once before mixing the dispersion (E) with the epoxy resin (A), the core-shell polymer (B) being prepared by the above-described process, it is possible to further decrease the contents of water-soluble contaminants, such as an emulsifier, a dispersant, a water-soluble polymerization initiator, and a reductant, used in preparing the aqueous latex of the core-shell polymer (B) or to remove these compounds from the dispersion (E). In particular, it is possible to further decrease the contents of alkali metal ions or to remove the ions.

In the epoxy resin composition (C) prepared by the above-described process, preferably 80 percent by weight or more, more preferably 90 percent by weight or more, and particularly preferably 95 percent by weight or more of an anionic emulsifier used in polymerization for the core-shell polymer (B) is removed. As a result, it is possible to obtain an epoxy resin composition in which the content of the anionic emulsifier in the epoxy resin composition (C) is preferably 100 ppm or less, more preferably 60 ppm or less, and particularly preferably 30 ppm or less. The residual emulsifier may be determined, for example, by colorimetry as follows: the dispersion (E) before being mixed with the epoxy resin (A) is exsiccated, and the emulsifier is extracted with ethanol. The determination of the resulting extract is performed by colorimetry with methylene blue at a wavelength of 650 nm.

The contents of the alkali metal ions of the epoxy resin composition (C) prepared in the present invention are preferably 30 ppm or less, more preferably 15 ppm or less, and particularly preferably 10 ppm or less. The contents of the alkali metal ions may be determined for example by the following method: the epoxy resin composition (C) is decomposed by acidolysis under pressure, and then the resulting decomposition product is measured by inductively high-frequency induction plasma atomic emission spectrochemical analysis.

Examples of the specific organic solvent (I) mixed with the aqueous latex containing the core-shell polymer (B) include esters such as methyl acetate, ethyl acetate, propyl acetate, and butyl acetate; ketones such as acetone, methyl ethyl ketone, diethyl ketone, and methyl isobutyl ketone; alcohols such as ethanol, (iso)propanol, and butanol; ethers such as tetrahydrofuran, tetrahydropyran, dioxane, and diethyl ether; aromatic hydrocarbons such as benzene, toluene, and xylenes; and halogenated hydrocarbons such as methylene chloride and chloroform. These organic solvents may be used alone or in a mixture thereof. In particular, an exemplary organic solvent preferably has a water solubility of 5 percent by weight to 40 percent by weight at 20 °C. When the organic solvent (I) has a water solubility of less than 5 percent by weight, it tends to be rather difficult to mix the solvent with the aqueous latex containing the core-shell polymer (B). On the contrary, when the organic solvent (I) has a water solubility exceeding 40 percent by weight, it tends to become increasingly difficult to efficiently separate and remove the aqueous phase after adding the organic solvent immiscible with water-soluble electrolytes or the aqueous latex. The organic solvent (I) added to the aggregates (G) in preparing the dispersion (E) is not necessarily identical to the specific organic solvent (I) mixed with the aqueous latex containing the core-shell polymer (B).

A known process may be available for removing a volatile component containing the organic solvent from the mixture containing the resulting epoxy resin composition (C). Examples of the process include a batch process for feeding the mixture into a vessel and then removing by distillation (under reduced pressure); a process for bringing the mixture into countercurrent contact with a dry gas in a vessel; a continuous process such as using a film evaporator; a process using an extruder or continuous stirring vessel equipped with a vent or evaporating system. Processing conditions, such as temperate and time required, during removal of the volatile component may be appropriately selected within a range in which the epoxy resin (A) is not reacted or quality is not impaired. Such a process for removing the volatile component may be performed after addition of a curing agent or an additive depending on various applications for convenience of the applications.

An epoxy resin molding material of the present invention maybe obtained by appropriately mixing the resulting epoxy resin composition (C) or an epoxy resin composition containing the epoxy resin composition (C) in combination with a suitable epoxy resin according to need with at least one curing agent (K) or, curing catalyst, and an inorganic filler (L), and if necessary, an additive or a compound agent, such as a curing accelerator (M), a flame retardant, a coupling agent, a mold-releasing agent, or a pigment that are usually used for a semiconductor sealing material. Typical additives and compound agents used in this field may be used without problems.

Examples of the curing agent (K) that can be used include phenol resins such as a phenol novolac; aliphatic amines; aromatic amines; and carboxylic acid derivatives such as acid anhydrides or blocked carboxylic acids. Among these, from the standpoint of high heat resistance of a cured product to be obtained, the phenol resin is more preferably used. The content of the curing agent (K) varies depending on the sealing form for semiconductor devices but is usually 1 to 300 parts by weight for the epoxy resin composition (C) or the epoxy resin composition containing the epoxy resin composition (C) in combination with an appropriate epoxy resin according to need.

Examples of the curing accelerator (M) include imidazole compounds; tertiary amine compounds; and phosphine compounds such as triphenylphosphine. When photo-curing is applied, examples of the curing catalyst that can be used include aromatic sulfonium salts, aromatic diazonium salts, and aromatic iodonium salts. A known sensitizer, such as an anthracene derivative, may be used in appropriate combination. The content of the curing accelerator (M) or the curing catalyst varies depending on the sealing form for semiconductor devices but is usually 0.01 to 50 parts by weight for the epoxy resin composition (C) or the epoxy resin composition containing the epoxy resin composition (C) in combination with an appropriate epoxy resin according to need.

Examples of the inorganic filler (L) that can be used include fused silica, crystalline silica, alumina, calcium carbonate, boron nitride, and silicon carbide. The content of the inorganic filler (L) varies depending on the sealing form for semiconductor devices but is usually 0 to 2,000 parts by weight for 100 parts by weight of the epoxy resin composition (C) or the epoxy resin composition containing the epoxy resin composition (C) in combination with an appropriate epoxy resin according to need.

Examples of the flame retardant that can be used include bromobisphenol-A epoxy resin; other bromine-based flame retardants; phosphorus-based flame retardants such as condensed phosphates; metal hydroxide-based flame retardants such as magnesium hydroxide and aluminum hydroxide; and silicone resin-based flame retardants such as polysiloxane derivatives. The content of the flame retardant varies depending on the sealing form for semiconductor devices but is usually about 0 to 100 parts by weight for 100 parts by weight of the epoxy resin composition (C) or the epoxy resin composition containing the epoxy resin composition (C) in combination with an appropriate epoxy resin according to need. These flame retardants may be used alone or in appropriate combination.

Examples of the coupling agent include epoxysilanes, aminosilanes, alkylsilanes, vinylsilanes, and organotitanates. Examples of the mold-releasing agent include natural wax, synthetic wax, and esters. An example of a colorant is carbon black. The contents of the coupling agent, the mold-releasing agent, and the colorant vary depending on the sealing form for semiconductor devices but each are usually about 0 to 50 parts by weight for 100 parts by weight of the epoxy resin composition (C) or the epoxy resin composition containing the epoxy resin composition (C) in combination with an appropriate epoxy resin according to need.

Examples of a general method for producing an epoxy resin molding material of the present invention using such materials includes a method for mixing predetermined amounts of materials fed with a mixer or the like, melt-kneading the resulting mixture by heat rollers or the like, and forming a shape or pulverizing the mixture under cooling; and a method for mixing and dissolving the predetermined amounts of materials fed in an organic solvent, applying the resulting solution onto a support composed of polyimide, glass, or the like, and drying the solution to produce a molding material in the form of a sheet. These methods have been widely used. In mixing these materials, the core-shell polymer (B) has been stably dispersed in the form of primary particles in the epoxy resin composition (C). Therefore, it is possible to mix the materials easily and uniformly without a special apparatus. In mixing and curing, since the shell portion of the core-shell polymer (B) has an affinity for or reactivity to the epoxy resin, the dispersion failure or reaggregation of the core-shell polymer (B) does not occur. Therefore, an epoxy resin molding material for sealing semiconductor devices can be prepared, the epoxy resin molding material having satisfactory reproducibility of physical properties.

When the epoxy resin molding material of the present invention is used as a semiconductor sealing material, a known method, such as transfer molding, injection molding, a method for directly bonding an electronic device onto a substrate and, at the same time, sealing the device with a sealing material of a liquid or semi-cured sheet epoxy resin material, cast molding, or compression molding, may be widely available.

Examples

The present invention will be described in detail based on Examples. However, the present invention is not limited to these Examples.

Hereinafter, the amount of residual impurities was analyzed using the amount of emulsifier (anionic surfactant) and the total amount of ions as indicators. After preparation of an ultra-thin section of a cured product prepared from the resulting epoxy resin composition, the dispersion state of a core-shell polymer in an epoxy resin component was observed and evaluated with a transmission electron microscope (TEM).

Methods of analysis and measurement employed in the present invention will now be described before Examples.

[1] Amount of residual emulsifier

With respect to the amount of residual emulsifier, the amount of emulsifier remaining in a dispersion (E) before being mixed with an epoxy resin (A) was measured by an analytical method described below. The ratio (percent by weight) of the resulting amount of emulsifier to 100 percent by weight of the total amount of emulsifier used for polymerization of a core-shell polymer (B) was calculated and used as indicator. Furthermore, after preparation of an epoxy resin composition (C), the weight ratio (ppm) of the amount of emulsifier remaining in the system to the amount of the system was calculated and then used as an indicator.

[1-1] Sample pretreatment

In methods described in Examples described below, 5 mL of the dispersion (E) of the core-shell polymer (B) before being mixed with the epoxy resin (A) was exsiccated. The resulting residue was fed into a beaker with 50 mL of ethanol, and the resulting mixture was stirred for 10 minutes. The supernatant fluid was used as an analytical sample in a methylene blue method.

[1-2] Measurement by methylene blue method

To a separating funnel, 30 mL of water, 10 mL of an alkaline sodium borate solution, and 5 mL of a methylene blue solution (0.025 percent by weight aqueous solution) were fed, and 20 mL of chloroform was added thereto. The resulting mixture was shaken for 3 to 5 minutes, and then a chloroform layer was separated and removed. The addition and removal of chloroform were repeated until the chloroform layer was no longer colored. Next, 3 mL of dilute sulfuric acid (2.9 percent by weight aqueous solution), 20 mL of chloroform, and 2 mL of the sample prepared in [1-1] were added thereto, and the resulting mixture was shaken for 3 to 5 minutes. Then, the amount of emulsifier remaining in the dispersion (E) before being mixed with the epoxy resin (A) was measured in terms of absorption at a wavelength of 650nm with a spectrophotometer (spectrophotometer UV-2200, manufactured by Shimadzu Corporation) using the chloroform layer. The alkaline sodium borate solution was prepared by mixing 500 mL of 1.9 percent by weight sodium tetraborate decahydrate aqueous solution with 500 mL of 0.4 percent by weight sodium hydroxide aqueous solution.

[2] Analysis of content of alkali metal ions

[2-1] Pretreatment

Sulfuric acid and nitric acid were added to the epoxy resin composition (C), and the resulting mixture was subjected to acidolysis under pressure with a microwave decomposition apparatus (MLS-1200 MEGA, manufactured by Milestone General K.K.).

[2-2] Analysis of amount of electrolyte by ICP mass spectrometry (ICP-MS quantitative analysis)

The amounts of sodium ions and potassium ions were measured by inductively high-frequency induction plasma atomic emission spectrochemical analysis using Model HP-4500 manufactured by Yokogawa Analytical Systems Inc., under cool plasma conditions with cobalt as an internal standard according to absolute calibration method. The sum of the resulting measurements was defined as the alkali metal ion content.

[3] Ratio of organic solvent in aggregates (G)

The solid contents (SC) and water contents (WC) of the aggregates (G) prepared by methods described in Examples and Comparative examples were measured by the following method, and then the ratio of an organic solvent in the aggregates (G) was calculated by the following equation:

$$\text{Ratio of organic solvent in aggregates (G)} = 100 - (SC + WC)$$

[3-1] Measurement of solid content (SC) of aggregates (G)

A predetermined amount of aggregates (G) was dried in a hot air oven. The solid content (SC) of the aggregates (G) was calculated from the change in weight before and after drying.

[3-2] Measurement of water content (WC) of aggregates (G)

A predetermined amount of aggregates (G) was dispersed in a soluble solvent. The water content in the aggregates (G) was measured by a Karl Fischer's method, and the water content (WC) of the entire aggregates (G) was calculated.

[4] Quantitative determination of core-shell polymer (B) component contained in aqueous phase

A part of the aqueous phase discharged by a method described in each Example and Comparative example was separated and sufficiently dried at 120 °C to obtain a residue. The amount of residue is defined as the amount of core-shell polymer (B) component contained in the part of the aqueous phase.

[5] Volatile component in epoxy resin composition

In Examples and Comparative examples, to obtain an epoxy resin composition, distillation under reduced pressure was continued until the concentration of a volatile component, defined below, reached 5,000 ppm. About 3 g of the epoxy resin composition was weighed precisely and heated at a set temperature of 170 °C for 20 minutes in a hot air oven. The weights before and after heating were measured. The ratio of the decrement of the weight during volatilization was calculated as a volatile component (ppm).

[6] Dispersion state of core-shell polymer in epoxy resin composition

[6-1] Preparation of cured epoxy resin

To an Ishikawa-type grinder (manufactured by Ishikawa Kojo), 100 parts by weight of a prepared epoxy resin composition, a phenol resin as a curing agent (50 parts by weight, PSM-4261, manufactured by Gunei Chemical Industry Co., Ltd. (in Example using o-cresol novolac-type epoxy resin) or 85 parts by weight, Mirex XLC-LL, manufactured by Mitsui Chemicals, Inc. (in Example using phenol-type epoxy resin)), 2 parts by weight of triphenylphosphine (TPP) (manufactured by KI Chemical Industry Co., Ltd.) as a curing accelerator, 2 parts by weight of carnauba wax (manufactured by Toa Kasei Co., Ltd.), 900 parts by weight of fused silica (FB-940A, manufactured by Denki Kagaku Kogyo Kabushiki Kaisha), and 5 parts by weight of a coupling agent (KBM-403, manufactured by Shin-Etsu Chemical Co., Ltd.) were charged, and premixing was performed with the grinder for 10 minutes. Then, the mixture was kneaded with a two-roll kneader (manufactured by Inoue manufacturing Inc.) at 100 °C for 5 minutes. The resulting epoxy resin molding material was molded with a transfer molding machine (manufactured by Marushichi Iron Works Co., Ltd.) under the following conditions to form rectangular cured products (10 x 70 x 3 mm) : the amount fed: 45 g, molding temperature: 175 °C, molding pressure: 70 kgf/cm$^2$, transfer ram speed: 5 cm/sec, and molding time: 3 minutes.

[6-2] Observation of dispersion state of core-shell polymer with transmission electron microscope

Part of the resulting cured product was cut out. The core-shell polymer or rubber particles were stained with osmium oxide, and then a thin section was cut out. The thin section was observed with a transmission electron microscope (Model JEM 1200EX, manufactured by JEOL. Ltd.) at 10,000 magnification. The dispersion state of the core-shell polymer or rubber particles in the cured epoxy resin product was evaluated according to the following criteria:

> E: At least 90% of the number of particles of the core-shell polymer were not aggregated together and independently dispersed in the epoxy resin (A).
> G: At least 70% to less than 90% of the number of particles of the core-shell polymer were not aggregated together and independently dispersed in the epoxy resin (A).
> P: At least 10% to less than 70% of the number of particles of the core-shell polymer were not aggregated together and independently dispersed in the epoxy resin (A).
> T: Less than 10% of the number of particles of the core-shell polymer were not aggregated together and independently dispersed in the epoxy resin (A).

[7] Evaluation of physical properties

[7-1] Preparation of molding material for semiconductor sealing

Materials were preliminarily mixed with an Ishikawa-type grinder (manufactured by Ishikawa Kojo) for 10 minutes in amounts shown in Table 1. Then, the mixture was kneaded with a roll mill including two rollers for kneading (manufactured by Inoue manufacturing Inc) at 100 °C for 5 minutes to prepare an epoxy resin molding material for a semiconductor sealing material.

[7-2] Measurement of gelation time (plate method)

Measurement was performed with a gelation tester (manufactured by Nissin Kagaku CO., LTD) at 175 °C.

[7-3] Preparation of specimen

The resulting molding material obtained in [7-1] was molded with a transfer molding machine (manufactured by Marushichi Iron Works Co., Ltd.) under the following conditions to form rectangular specimens (10 × 70 × 3 mm), square plate specimens (70 × 70 × 3 mm), and circular specimens (50 mm in diameter, 3 mm in thick) : the amount fed: 45 g, molding temperature: 175°C, molding pressure: 70 kgf/cm$^2$, transfer ram speed: 5 cm/sec, and molding time: 3 minutes.

[7-4] Measurement of spiral flow

Measurement was carried out with a transfer molding machine (manufactured by Marushichi Iron Works Co. , Ltd.) under the following conditions: the amount fed: 18 to 20 g, molding temperature: 175 °C, molding pressure: 70 kgf/cm$^2$, molding time: 3 minutes, and transfer ram speed: 5 cm/sec.

[7-5] Glass transition temperature (Tg) and coefficient of linear expansion (TMA method)

Measurement was carried out with Model TMA SS120 manufactured by Seiko Instruments Inc., under the following conditions: measurement temperature: room temperature to 300 °C, heating rate: 5 °C/min, and nitrogen flow rate: 50 mL/min.

[7-6] Bending strength and elastic modulus

Measurements were carried out with Model Instron 5582 manufactured by Instron Corporation using rectangular specimens according to JIS K 7171 under the following conditions: test speed: 1.5 mm/min, distance between supporting points: 48 mm, and test temperature: 23 °C.

[7-7] Peel strength on aluminum

Measurement was carried out with Model Instron 5582 manufactured by Instron Corporation using the square specimen under the following conditions: substrate width: 10 mm, peel angle: 90°, test speed: 50 mm/min, and test temperature: 23 °C.

[7-8] Pressure cooker test

Test was run at 120°C and 2 atm for 24 hours. Measurement of water absorption and extracted ion analysis (sodium, potassium, and sulfate radical; Model DX-500, manufactured by Dionex Corporation) were carried out.

(Production Example 1) Production of core-shell polymer (B) latex

To a 100-L pressure-resistant reactor, 200 parts by weight of water 0.03 parts by weight of tripotassium phosphate, 0.25 parts by weight of potassium dihydrogen phosphate, 0.002 parts by weight of ethylenediaminetetraacetic acid, 0.001 parts by weight of ferrous sulfate, and 1.5 parts by weight of sodium dodecylbenzenesulfonate were charged. After nitrogen purge was sufficiently performed under stirring to remove oxygen, 75 parts by weight of butadiene and 25 parts by weight of styrene were added to the system, and the temperature was raised to 45°C. Then, 0.015 parts by weight of p-menthane hydroperoxide and 0.04 parts by weight of sodium formaldehyde sulfoxylate were added thereto to initiate polymerization. At 4 hours after initiation of the polymerization, 0.01 parts by weight of p-menthane hydroperoxide, 0.0015 parts by weight of ethylenediaminetetraacetic acid, and 0.001 parts by weight of ferrous sulfate were added. At 10 hours after initiation of the polymerization, residual monomers were devolatilized under reduced pressure to complete the polymerization. The polymerization conversion was 98%. The resulting styrene-butadiene rubber latex had a volume average particle diameter of 0.1 μm.
To a 3-L glass vessel, 1,300 g of the resulting rubber latex (containing 420 g of styrene-butadiene rubber particles and 1.5 percent by weight of sodium dodecylbenzenesulfonate as an emulsifier for the solid content of the rubber) and 440 g of pure water were fed. The resulting mixture was stirred at 70 °C under nitrogen purging. After addition of 1.2 g of azobisisobutyronitrile (AIBN), a mixture of 60 g of styrene, 50 g of methyl methacrylate, 30 g of acrylonitrile, and 40 g of glycidyl methacrylate was continuously added over a period of 3 hours to perform graft polymerization. After completion of the addition, stirring was continued for another 2 hours to finish the reaction, thereby resulting in a core-shell polymer (B) latex. The polymerization conversion was 99.5%. The resulting latex was used without any conditioning.

Example 1

To a 1-L vessel (inner diameter: 100 mm) equipped with a stirrer (with 3 impellers provided on the shaft in the axial direction, each impeller 75 mm in diameter having 4 flat paddles), 126 g of methyl ethyl ketone (solubility in water:

10 percent by weight at 20 °C) was charged. Then, 126 g of the aqueous core-shell polymer (B) latex prepared in Production example 1 was added under stirring at 500 rpm. After the mixture was mixed into a homogeneous mixture, 200 g of water was added at a feeding speed of 80 g/min under stirring at 500 rpm. After completion of the addition, stirring was stopped immediately to obtain a slurry including floating aggregates (G) and an aqueous phase containing a part of the organic solvent. Next, 348 g of the aqueous phase was drained from a discharge port at the base of the vessel while leaving the aggregates (G) containing a part of the aqueous phase. The aggregates (G) containing a part of the aqueous phase weighed 104 g. The ratio of the organic solvent to the entire weight of the aggregates was 39 percent by weight. The aggregates (G) were floating ability. The particles of the aggregates had particle size distribution. Samples of the aggregates were analyzed by image analysis. As a result, the number-average particle diameter was about 5 mm. The concentration of the core-shell polymer (B) in the drained aqueous phase was 0.1 percent by weight. The resulting aggregates (G) were filtered and dehydrated with a filter mounted on a suction flask and dried in a nitrogen atmosphere at 40 °C for 12 hours in a box dryer to obtain core-shell polymer (B) particles. The resulting aggregates were sampled, and methyl ethyl ketone was added to form a dispersion dope. The residual emulsifier and electrolytes were measured. As a result, the rates of removal were 95% and 90%, respectively. Next, 65 g of methyl ethyl ketone was added to 50.0 g of the resulting aggregates. The resulting mixture was mixed for 30 minutes under stirring at 500 rpm to form a homogeneous dispersion containing the core-shell polymer. The dispersion was placed in a 1-L vessel (inner diameter: 100 mm) equipped with a jacket and a stirrer (with an impeller 90 mm in diameter having an anchor blade), and 169.0 g of o-cresol novolac-type epoxy resin (Sumiepoxy ESCN 195XL-4 manufactured by Sumitomo Chemical Co. Ltd.) was added thereto. After the mixture was mixed into a homogeneous mixture, the jacket temperature was set at 110 °C. A volatile component was distilled off under reduced pressure with a vacuum pump (TSW-150, oil-sealed rotary vacuum pump, manufactured by Sato Vac Inc). The distillation was continued until the concentration of the volatile component reached a predetermined value (5,000 ppm). A nitrogen gas was introduced into the vessel to allow the internal pressure to return to atmospheric pressure. Then, the contents in a molten state were cast on a fluorocarbon resin sheet and left standing to cool and solidify, followed by pulverization to form a flaky, pale yellow epoxy resin composition. The time required for volatilization was 4 hours. The content of the alkali metal ions of this epoxy resin composition was 9.0 ppm. The content of the residual emulsifier was 53 ppm. As a result of the observation of the dispersion state of the core-shell polymer in a cured product produced from this epoxy resin composition, the core-shell polymer was homogeneously dispersed without aggregation. An epoxy resin molding material for sealing semiconductor devices was prepared using the resulting epoxy resin composition in amounts shown in Table 1, and then physical properties were evaluated. Table 2 shows the evaluation results.

Example 2

An epoxy resin molding material was produced using the epoxy resin composition prepared in EXAMPLE 1 in amounts shown in Table 1, and physical properties were evaluated. Table 2 shows the evaluation results.

Example 3

To a 1-L vessel equipped with a stirrer (inner diameter: 100 mm, stirrer with an impeller 56 mm in diameter having three retreating blades), 144 g of methyl ethyl ketone was charged. Then, 144 g of the aqueous core-shell polymer (B) latex prepared in Production example 1 was added under stirring at 400 rpm, and the resulting mixture was mixed into a homogeneous mixture. Then, 207 g of water was introduced carefully from a discharge port at the base of the vessel without stirring, and the resulting mixture was stirred at 400 rpm for 2 minutes. After completion of the stirring, a slurry including aggregates (G) (floating) and an aqueous phase containing a part of the organic solvent was obtained. Next, 373 g of the aqueous phase was drained from the discharge port at the base of the vessel while leaving the aggregates (G) containing a part of the aqueous phase. The aggregates (G) containing a part of the aqueous phase weighed 122 g. The ratio of the organic solvent to the entire weight of the aggregates (G) was 45 percent by weight. The number-average particle diameter of the aggregates (G) was about 5 mm. The concentration of the core-shell polymer (B) in the drained aqueous phase was 0.2 percent by weight. Hereinafter, core-shell polymer (B) particles were obtained by the same procedure as that in EXAMPLE 1. Methyl ethyl ketone was added to sampling of the resulting aggregates to form a dispersion dope. The residual emulsifier and electrolytes were measured. As a result, the rates of removal were 92% and 87%, respectively. Next, 120 g of methyl ethyl ketone was added to 70.0 g of the resulting aggregates. The resulting mixture was mixed for 30 minutes under stirring at 500 rpm to form a homogeneous dispersion (E) containing the core-shell polymer (B). This dispersion (E) was placed in a 1-L vessel (inner diameter: 100 mm) equipped with a jacket and a stirrer (with an impeller 90 mm in diameter having anchor blade), 117.8 g of a biphenyl-type epoxy resin (YX4000H, manufactured by Japan Epoxy Resins Co., Ltd.) was added thereto. After the mixture was mixed into a homogeneous mixture, the jacket temperature was set at 90 °C. A volatile component was distilled off under reduced pressure with a vacuum pump (TSW-150, oil-sealed rotary vacuum pump, manufactured by Sato Vac Inc.).

The distillation was continued until the concentration of the volatile component reached a predetermined value (5,000 ppm). A nitrogen gas was introduced into the vessel to allow the internal pressure to return to atmospheric pressure. Then, the contents in a molten state were cast on a fluorocarbon resin sheet and left standing to cool and solidfy, followed by pulverization to form a flaky, pale yellow epoxy resin composition (C). The time required for volatilization was 5 hours. The content of the alkali metal ions of this epoxy resin composition was 19.6 ppm. The content of the residual emulsifier was 47 ppm. As a result of the observation of the dispersion state of the core-shell polymer (B) in a cured product produced from this epoxy resin composition, the core-shell polymer (B) was homogeneously dispersed without aggregation. An epoxy resin molding material for sealing semiconductor devices was prepared using the resulting epoxy resin composition in amounts shown in Table 1, and then physical properties were evaluated. Table 2 shows the evaluation results.

Example 4

An epoxy resin molding material for sealing semiconductor was produced using the epoxy resin composition prepared in EXAMPLE 3 in amounts shown in Table 1, and physical properties were evaluated. Table 2 shows the evaluation results.

Comparative Example 1

As shown in Table 1, an epoxy resin molding material for sealing semiconductor devices was prepared as in EXAMPLE 1, except that a commercially available non-core-shell silicone rubber particles (Torayfil E601, manufactured by Toray

Industries Inc.) instead of the epoxy resin composition containing the core-shell polymer (B) of the present invention were mixed in an amount of 10 percent by weight for the o-cresol novolac-type epoxy resin component. Physical properties were evaluated. Table 2 shows the evaluation results.

Comparative Example 2

As shown in Table 1, an epoxy resin molding material for sealing semiconductor devices was prepared as in EXAMPLE 3, except that a commercially available non-core-shell silicone rubber particles (Torayfil E601, manufactured by Toray Industries Inc.) instead of the epoxy resin composition containing the core-shell polymer (B) of the present invention were mixed in an amount of 10 percent by weight for the biphenyl-type epoxy resin component. Physical properties were evaluated. Table 2 shows the evaluation results.

Comparative Example 3

To a 1-L vessel (inner diameter: 100 mm) equipped with a stirrer (with 3 impellers provided on the shaft in the axial direction, each impeller 75 mm in diameter having 4 flat paddles), 500 g of the aqueous core-shell polymer (B) latex prepared in Production example 1. Then, 13 g of a 35% by weight calcium chloride ($CaCl_2$) aqueous solution was added as a coagulant under stirring at 400 rpm to form aggregates. The resulting slurry containing the aggregates was heated to 60°C and cooled to 23°C under stirring. This slurry was filtered and dehydrated with a filter mounted on a suction flask and dried at 40 °C for 12 hours in a box dryer to obtain a core-shell polymer (B) particle powder.
As shown in Table 1, an epoxy resin molding material for sealing semiconductor devices was prepared as in EXAMPLE 3, except that the resulting core-shell polymer (B) particle powder was mixed in an amount of 10 percent by weight for the biphenyl-type epoxy resin component. Physical properties were evaluated. Table 2 shows the evaluation results.

Comparative Example 4

As shown in Table 1, an epoxy resin molding material for sealing semiconductor devices was prepared without the epoxy resin composition containing the core-shell polymer (B) of the present invention. Physical properties were evaluated. Table 2 shows the evaluation results.

Table 1

| | 1 | 2 | 3 | 4 | 5 | 6 | 7 | 8 |
|---|---|---|---|---|---|---|---|---|
| | Example 1 | Example 2 | Example 3 | Example 4 | Comparative example 1 | Comparative Example 2 | Comparative Example 3 | Comparative Example 4 |
| Residual emulsifier (ppm) | 53 | 27 | 47 | 24 | - | - | - | - |
| $Na^+$ (ppm) | 5.2 | ← | 10.8 | ← | - | - | 126 | - |
| $K^+$ (ppm) | 3.8 | ← | 8.8 | ← | - | - | 22 | - |
| Epoxy resin composition | 100 | 50 | 56 | 28 | | | | |
| ESCNI95XL | | 50 | | | 90 | | | |
| YX4000H | | | 44 | 72 | | 90 | 90 | 100 |
| PSM-4261 | 50 | 50 | | | 50 | 85 | 85 | 85 |
| Mirex | | | 85 | 85 | | | | |
| Rubber particle component | | | | | 10 | 10 | 10 | |
| TPP | 2 | 2 | 2 | 2 | 2 | 2 | 2 | 2 |
| Carnauba wax | 2 | 2 | 2 | 2 | 2 | 2 | 2 | 2 |
| KBM-403 | 5 | 5 | 5 | 5 | 5 | 5 | 5 | 5 |
| FB-940 | 900 | 900 | 1100 | 1100 | 900 | 1100 | 1100 | 1100 |

Table 2

| | 1 | 2 | 3 | 4 | 5 | 6 | 7 | 8 |
|---|---|---|---|---|---|---|---|---|
| | Example 1 | Example 2 | Example 3 | Example 4 | Comp. Example 1 | Comp. Example 2 | Comp. Example 3 | Comp. Example 4 |
| Dispersion state of core-shell polymer (or rubber particles) | E | E | E | E | P | P | T | - |
| Gel time at 175 °C (s) | 24 | 24 | 21 | 21 | 25 | 22 | 22 | 21 |
| Spiral flow (cm) | 65.6 | 80.1 | 92.8 | 98.9 | 82.3 | 99.5 | 80.2 | 102.7 |
| Glass transition temperature (°C) | 163 | 1.44 | 125 | 118 | 140 | 119 | 119 | 119 |
| Linear expansion coefficient at 23 °C to Tg ($\times 10^{-5}$/°C) | 1.23 | 1.23 | 1.25 | 1.29 | 1.23 | 1.37 | 1.37 | 1.40 |
| Linear expansion coefficient at Tg to 300 °C ($\times 10^{-5}$/°C) | 3.54 | 3.71 | 4.13 | 4.37 | 3.65 | 4.75 | 4.48 | 4.27 |
| Bending strength (MPa) | 140 | 149 | 170 | 171 | 152 | 164 | 163 | 166 |
| Flexural modulus (GPa) | 21.0 | 21.6 | 20.3 | 21.1 | 23.0 | 22.6 | 23.0 | 23.0 |
| Peel strength on Al (N/cm) | 3.3 | 3.5 | 6.3 | 7.2 | 2.4 | 4.8 | 4.5 | 6.1 |
| Water absorption coefficient (%) (121°C, 2atm, 24h) | 0.3 | 0.31 | 0.31 | 0.31 | 0.3 | 0.31 | 0.42 | 0.32 |

The results clearly show that use of the inventive epoxy resin molding material for a semiconductor sealing material reduces a satisfactory dispersion of a core-shell polymer and decreases the amounts of residual emulsifier and metal ions that cause decreased moisture resistance reliability. Furthermore, satisfactory heat resistance, good peeling resistance, and a high effect of decreasing internal stress can be achieved.

**Claims**

1.   An epoxy resin composition (C) for sealing semiconductor, comprising an epoxy resin (A); and a core-shell polymers (B) comprising at least one rubber layer,
wherein
at least 70% of the core-shell polymer (B) is dispersed in the form of primary particles in a resin phase containing the epoxy resin, and
the epoxy resin composition (C) contains not more than 30 ppm of an alkali metal ion, and wherein
the core-shell polymer (B) is a polymer comprising a multilayer structure comprising at least two layers including at least one crosslinked rubbery polymer layer, and which core-shell polymer (B) is a graft copolymer comprising 40 to 95 percent by weight of a rubber particle core (B-1) and 5 to 60 percent by weight of a shell layer (B-2),
the rubber particle core (B-1) comprising a rubber elastomer, an elastic polysiloxane rubber, or a mixture of the rubber elastomer and the elastic polysiloxane rubber,
the rubber elastomer comprising at least 50 percent by weight of at least one monomer selected from a diene monomer and a (meth)acrylate monomer and 50 percent by weight or less of another copolymerizable vinyl monomer,
the shell layer (B-2) comprising a polymer prepared by polymerizing at least one polymerizable vinyl monomer selected from a (meth)acrylate, an aromatic vinyl, vinyl cyanide, an unsaturated acid derivative, a (meth)acrylamide derivative, and a maleimide derivative,and
the shell layer (B-2) further comprising an epoxy group, and the epoxy equivalent value is not more than 4,500 for the entire core-shell polymer (B).

2. The epoxy resin composition (C) for sealing semiconductor according to claim 1, wherein the epoxy resin composition (C) contains not more than 100 ppm of an anionic emulsifier.

3. The epoxy resin composition (C) for sealing semiconductor according to claim 1 or 2, wherein the epoxy resin composition (C) is prepared by mixing an aqueous latex comprising the core-shell polymer (B) comprising at least one rubber layer with an organic solvent (I) to form a mixture (F),
bringing the mixture (F) into contact with water to form aggregates (G) of the core-shell polymer (B) in an aqueous phase (H), the aggregates (G) comprising the organic solvent (I),
separating the aggregates (G) from the aqueous phase (H), and
mixing the aggregates (G) with the epoxy resin (A).

4. The epoxy resin composition (C) for sealing semiconductor according to claim 1 or 2, wherein the epoxy resin composition (C) is prepared by mixing an aqueous latex comprising the core-shell polymer (B) comprising at least one rubber layer with an organic solvent (I) to form a mixture (F),
bringing the mixture (F) into contact with water to form aggregates (G) of the core-shell polymer (B) in an aqueous phase (H), the aggregates (G) comprising the organic solvent (I),
separating the aggregates (G),
adding an organic solvent (I) to form a dispersion (E) containing the core-shell polymer (B) dispersed in the organic solvent (I), and
mixing the dispersion (E) with the epoxy resin (A).

5. The epoxy resin composition (C) for sealing semiconductor according to any one of claims 1 to 4, wherein, in preparing the epoxy resin composition (C), before mixing the dispersion (E) with the epoxy resin (A), steps of bringing the dispersion (E) into contact with water and then separating an aqueous phase are performed at least once.

6. The epoxy resin composition (C) for sealing semiconductor according to any one of claims 1 to 5, wherein at least 90% of the core-shell polymer (B) is dispersed in the form of primary particles in the resin phase containing the epoxy resin, and the epoxy resin composition (C) contains not more than 15 ppm of the alkali metal ion.

7. The epoxy resin composition (C) for sealing semiconductor according to claim 6, wherein the epoxy resin composition (C) contains not more than 60 ppm of an anionic emulsifier.

8. The epoxy resin composition (C) for sealing semiconductor according to any one of claims 1 to 7, wherein the epoxy resin (A) comprises not less than 50 percent by weight of at least one epoxy resin selected from a diglycidyl ether of a biphenol or an aromatic nucleus-substituted biphenol or a condensate thereof, a novolac-type epoxy resin, a dicyclopentadienyl-type epoxy resin, and an alicyclic epoxy resin containing a cycloolefin oxide skeleton structure per molecule, for the total amount of epoxy resin (A).

9. An epoxy resin molding material for sealing semiconductor, wherein the epoxy resin molding material comprises the epoxy resin composition (C) according to any one of claims 1 to 8, a curing agent (K), an inorganic filler (L), and,

if necessary, a curing accelerator (M).

**Patentansprüche**

1. Eine Epoxidharzzusammensetzung (C) zur Halbleiterversiegelung, umfassend ein Epoxidharz (A); und ein Kern-Hülle-Polymer (B), umfassend mindestens eine Kautschukschicht,
wobei
mindestens 70% des Kern-Hülle-Polymers (B) in Form von Primärteilchen in einer Harzphase dispergiert sind, die das Epoxidharz enthält,
und
die Epoxidharzzusammensetzung (C) nicht mehr als 30 ppm eines Alkalimetallions enthält, und wobei das Kern-Hülle-Polymer (B) ein Polymer ist, welches eine Mehrschichtstruktur, umfassend mindestens zwei Schichten einschließlich mindestens einer vernetzten kautschukartigen Polymerschicht umfasst, und wobei das Kern-Hülle-Polymer (B) ein Pfropfcopolymer ist, das 40 bis 95 Gewichtsprozent eines Kautschukteilchenkerns (B-1) und 5 bis 60 Gewichtsprozent einer Hüllschicht (B-2) umfasst,
wobei der Kautschukteilchenkern (B-1) ein Kautschukelastomer, einen elastischen Polysiloxankautschuk oder ein Gemisch des Kautschukelastomers und des elastischen Polysiloxankautschuks umfasst,
wobei das Kautschukelastomer mindestens 50 Gewichtsprozent von mindestens einem Monomer, ausgewählt aus einem Dienmonomer und einem (Meth)acrylatmonomer, und 50 Gewichtsprozent oder weniger eines anderen copolymerisierbaren Vinylmonomers umfasst, wobei die Hüllschicht (B-2) ein Polymer umfasst, welches durch Polymerisieren von mindestens einem polymerisierbaren Vinylmonomer, ausgewählt aus einem (Meth)acrylat, einem aromatischen Vinyl, Vinylcyanid, einem ungesättigten Säurederivat, einem (Meth)acrylamidderivat und einem Maleimidderivat, hergestellt ist, und
wobei die Hüllschicht (B-2) ferner eine Epoxidgruppe umfasst und der Epoxidäquivalentwert nicht mehr als 4.500 für das gesamte Kern-Hülle-Polymer (B) beträgt.

2. Die Epoxidharzzusammensetzung (C) zur Halbleiterversiegelung gemäß Anspruch 1, wobei die Epoxidharzzusammensetzung (C) nicht mehr als 100 ppm eines anionischen Emulgators enthält.

3. Die Epoxidharzzusammensetzung (C) zur Halbleiterversiegelung gemäß Anspruch 1 oder 2, wobei die Epoxidharzzusammensetzung (C) hergestellt ist durch Mischen eines wässrigen Latex, umfassend das Kern-Hülle-Polymer (B), das mindestens eine Kautschukschicht umfasst, mit einem organischen Lösungsmittel (I), um ein Gemisch (F) zu bilden,
Inkontaktbringen des Gemisches (F) mit Wasser, um Aggregate (G) des Kern-Hülle-Polymers (B) in einer wässrigen Phase (H) zu bilden, wobei die Aggregate (G) das organische Lösungsmittel (I) umfassen,
Abtrennen der Aggregate (G) aus der wässrigen Phase (H), und
Mischen der Aggregate (G) mit dem Epoxidharz (A).

4. Die Epoxidharzzusammensetzung (C) zur Halbleiterversiegelung gemäß Anspruch 1 oder 2, wobei die Epoxidharzzusammensetzung (C) hergestellt ist durch Mischen eines wässrigen Latex, umfassend das Kern-Hülle-Polymer (B), das mindestens eine Kautschukschicht umfasst, mit einem organischen Lösungsmittel (I), um ein Gemisch (F) zu bilden,
Inkontaktbringen des Gemisches (F) mit Wasser, um Aggregate (G) des Kern-Hülle-Polymer (B) in einer wässrigen Phase (H) zu bilden, wobei die Aggregate (G) das organische Lösungsmittel (I) umfassen,
Abtrennen der Aggregate (G),
Zugeben eines organischen Lösungsmittels (I), um eine Dispersion (E) zu bilden, die das in dem organischen Lösungsmittel (I) dispergierte Kern-Hülle-Polymer (B) enthält, und
Mischen der Dispersion (E) mit dem Epoxidharz (A).

5. Die Epoxidharzzusammensetzung (C) zur Halbleiterversiegelung gemäß einem der Ansprüche 1 bis 4, wobei bei der Herstellung der Epoxidharzzusammensetzung (C), vor dem Mischen der Dispersion (E) mit dem Expoxidharz (A), Schritte des Inkontaktbringens der Dispersion (E) mit Wasser und dann Abtrennen einer wässrigen Phase mindestens einmal durchgeführt werden.

6. Die Epoxidharzzusammensetzung (C) zur Halbleiterversiegelung gemäß einem der Ansprüche 1 bis 5, wobei mindestens 90% des Kern-Hülle-Polymers (B) in Form von Primärteilchen in der Harzphase dispergiert sind, die das Epoxidharz enthält, und die Epoxidharzzusammensetzung (C) nicht mehr als 15 ppm des Alkalimetallions enthält.

**7.** Die Epoxidharzzusammensetzung (C) zur Halbleiterversiegelung gemäß Anspruch 6, wobei die Epoxidharzzusammensetzung (C) nicht mehr als 60 ppm eines anionischen Emulgators enthält.

**8.** Die Epoxidharzzusammensetzung (C) zur Halbleiterversiegelung gemäß einem der Ansprüche 1 bis 7, wobei das Epoxidharz (A) nicht weniger als 50 Gewichtsprozent von mindestens einem Epoxidharz, ausgewählt aus einem Diglycidylether eines Bisphenols oder einem aromatischen kernsubstituierten Bisphenol oder einem Kondensat davon, einem Epoxidharz vom Novolaktyp, einem Epoxidharz vom Dicyclopentadienyltyp, und einem alicyclischen Epoxidharz, das eine Cycloolefinoxid-Gerüststruktur pro Molekül enthält, für die Gesamtmenge des Epoxidharzes (A) umfasst.

**9.** Eine Epoxidharzformmasse zur Halbleiterversiegelung, wobei die Epoxidharzformmasse die Epöxidharzzusammensetzung (C) gemäß einem der Ansprüche 1 bis 8, ein Härtungsmittel (K), einen anorganischen Füllstoff (L) und, falls notwendig, einen Härtungsbeschleuniger (M) umfasst.

## Revendications

**1.** Composition de résine époxy (C) pour sceller un semiconducteur, comprenant une résine époxy (A) ; et un polymère coeur-enveloppe (B) comprenant au moins une couche de caoutchouc,

dans laquelle

au moins 70 % du polymère coeur-enveloppe (B) sont dispersés sous la forme de particules primaires dans une phase de résine contenant la résine époxy, et

la composition de résine époxy (C) ne contient pas plus de 30 ppm d'ion de métal alcalin, et dans laquelle

le polymère coeur-enveloppe (B) est un polymère comprenant une structure multicouches comprenant au moins deux couches comprenant au moins une couche de polymère caoutchouteux réticulé, et dans laquelle le polymère coeur-enveloppe (B) est un copolymère greffé comprenant de 40 à 95 % en poids d'un coeur de particule de caoutchouc (B-1) et de 5 à 60 % en poids d'une couche d'enveloppe (B-2),

le coeur de particule de caoutchouc (B-1) comprenant un élastomère de caoutchouc, un caoutchouc polysiloxane élastique, ou un mélange de l'élastomère de caoutchouc et du caoutchouc polysiloxane élastique,

l'élastomère de caoutchouc comprenant au moins 50 % en poids d'au moins un monomère sélectionné parmi un monomère diénique et un monomère de (méth)acrylate et 50 % en poids ou moins d'un autre monomère vinylique copolymérisable,

la couche d'enveloppe (B-2) comprenant un polymère préparé par polymérisation d'au moins un monomère vinylique polymérisable-sélectionné parmi un (méth)acrylate, un vinyle aromatique, un cyanure de vinyle, un dérivé d'acide insaturé, un dérivé de (méth)acrylamide, et un dérivé de maléimide, et

la couche d'enveloppe (B-2) comprenant un groupe époxy, et la valeur équivalente en époxy n'est pas supérieure à 4500 pour tout le polymère coeur-enveloppe (B).

**2.** Composition de résine époxy (C) pour sceller un semiconducteur selon la revendication 1, dans laquelle la composition de résine époxy (C) ne contient pas plus de 100 ppm d'un émulsifiant anionique.

**3.** Composition de résine époxy (C) pour sceller un semiconducteur selon la revendication 1 ou 2, dans laquelle la composition de résine époxy (C) est préparée en mélangeant un latex aqueux comprenant le polymère coeur-enveloppe (B) comprenant au moins une couche de caoutchouc avec un solvant organique (I) pour former un mélange (F),

en amenant le mélange (F) en contact avec de l'eau pour former des agrégats (G) du polymère coeur-enveloppe (B) dans une phase aqueuse (H), les agrégats (G) comprenant le solvant organique (I),

en séparant les agrégats (G) de la phase aqueuse (H), et

en mélangeant les agrégats (G) avec la résine époxy (A).

**4.** Composition de résine époxy (C) pour sceller un semiconducteur selon la revendication 1 ou 2, dans laquelle la composition de résine époxy (C) est préparée en mélangeant un latex aqueux comprenant le polymère coeur-enveloppe (B) comprenant au moins une couche de caoutchouc avec un solvant organique (I) pour former un mélange (F),

en amenant le mélange (F) en contact avec de l'eau pour former des agrégats (G) du polymère coeur-enveloppe (B) dans une phase aqueuse (H), les agrégats (G) comprenant le solvant organique (I),

en séparant les agrégats (G),

en ajoutant un solvant organique (I) pour former une dispersion (E) contenant le polymère coeur-enveloppe (B) dispersé dans le solvant organique (I), et

en mélangeant la dispersion (E) avec la résine époxy (A).

5. Composition de résine époxy (C) pour sceller un semiconducteur selon l'une quelconque des revendications 1 à 4, dans laquelle, lors de la préparation de la composition de résine époxy (C), avant le mélange de la dispersion (E) avec la résine époxy (A), les étapes de mise en contact de la dispersion (E) avec de l'eau et ensuite de séparation d'une phase aqueuse sont réalisées au moins une fois.

6. Composition de résine époxy (C) pour sceller un semiconducteur selon l'une quelconque des revendications 1 à 5, dans laquelle au moins 90 % du polymère coeur-enveloppe (B) sont dispersés sous la forme de particules primaires dans la phase de résine contenant la résine époxy, et la composition de résine époxy (C) ne contient pas plus de 15 ppm de l'ion de métal alcalin.

7. Composition de résine époxy (C) pour sceller un semiconducteur selon la revendication 6, dans laquelle la composition de résine époxy (C) ne contient pas plus de 60 ppm d'un émulsifiant anionique.

8. Composition de résine époxy (C) pour sceller un semiconducteur selon l'une quelconque des revendications 1 à 7, dans laquelle la résine époxy (A) ne comprend pas moins de 50 % en poids d'au moins une résine époxy sélectionnée parmi un éther diglycidylique d'un biphénol ou d'un biphénol substitué sur le noyau aromatique ou d'un produit de condensation de ceux-ci, une résine époxy de type novolac, une résine époxy de type dicyclopentadiényle, et une résine époxy alicyclique contenant une structure de squelette d'oxyde de cyclooléfine par molécule, pour la quantité totale de résine époxy (A).

9. Matériau de moulage en résine époxy pour sceller un semiconducteur, dans lequel le matériau de moulage en résine époxy comprend la composition de résine époxy (C) selon l'une quelconque des revendications 1 à 8, un agent de durcissement (K), une charge inorganique (L), et, si nécessaire, un accélérateur de durcissement (M).

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 62034251 A
- JP 59138254 A
- CA 2164915
- JP 10287792 A
- US 3322852 A
- US 3496250 A
- JP 2003107882 A
- JP 2003164416 A
- JP 2003326711 A